# FASCICULE DE BREVET EUROPEEN

(11) **EP 3 902 381 B1**
(45) Date de publication et mention de la délivrance du brevet: **08.03.2023**
(21) Numéro de dépôt: 21168963.3
(22) Date de dépôt: 16.04.2021
(51) Int. Cl.: H05K 7/14, H05K 7/20

(54) **ENSEMBLE ÉLECTRIQUE MONTÉ SUR UN SUPPORT**
ELEKTRISCHE EINHEIT, DIE AUF EINE HALTERUNG MONTIERT IST
ELECTRICAL ASSEMBLY MOUNTED ON A SUPPORT

(30) Priorité: 21.04.2020 FR 2003960
(43) Date de publication de la demande: 27.10.2021
(73) Titulaire: Valeo eAutomotive France SAS, 95800 Cergy (FR)
(72) Inventeur: POUILLY, Aurélien, 95800 Cergy (FR); LEGENDRE, Alexandre, 95800 Cergy (FR)
(74) Mandataire: Valeo Powertrain Systems

(56) Documents cités:
- EP-A1- 3 621 093
- JP-A- 2005 243 803
- JP-A- 2006 210 561
- US-A1- 2012 206 950

## Description

### DOMAINE TECHNIQUE

La présente invention concerne le domaine des équipements électriques, notamment des onduleurs, pour véhicules électriques ou hybrides.

Plus précisément, la présente invention vise un ensemble électrique comprenant un support, sur lequel sont assemblés des composants électriques et mécaniques, notamment une capacité de liaison et un dispositif de refroidissement, ledit ensemble électrique étant destiné à être installé dans un châssis pour former un équipement électrique, notamment un onduleur.

Ledit support peut par exemple, mais non nécessairement, être un couvercle de l'équipement électrique.

### ETAT DE LA TECHNIQUE

Il est connu des équipements électriques, notamment des onduleurs ou des convertisseurs de puissance, comprenant des cartes électroniques, des composants électriques tels que des bobines et des éléments mécaniques connectés ou fixés et logés dans un châssis ou un boîtier, notamment fermé par un couvercle.

De tels équipements électriques sont notamment mis en oeuvre dans le domaine des véhicules automobiles. En particulier, dans des véhicules électriques ou hybrides, on utilise, pour réaliser un système de motorisation électrique, de tels équipements électriques aptes à fonctionner sous des tensions supérieures à 100 V.

Les documents JP2005243803, US2012206950, EP3621093 et JP2006210561 décrivent des ensembles électriques connus de l'art antérieur.

En particulier dans le domaine de la construction de véhicules automobiles, notamment électriques ou hybrides, il peut être requis, à des fins de compatibilités avec des processus d'assemblage spécifiques, de disposer d'ensembles électriques dépourvus de châssis ou de boîtier.

Il est alors rendu nécessaire de concevoir un ensemble électrique dont les composants électriques et mécaniques, les cartes électroniques éventuellement, tiennent ensemble, formant un ensemble solidaire, sans que ledit ensemble ne puisse, à un certain stade du processus d'assemblage, s'appuyer sur la référence mécanique que constitue normalement le châssis pour être maintenu.

Il existe alors un besoin pour un ensemble électrique comprenant différents composants, dont une capacité de liaison et un dispositif de dissipation thermique, assemblés sur un support, et adapté pour être manipulé de façon autonome en vue d'être inséré, à un stade ultérieur du processus d'assemblage, dans un châssis, pour former un équipement électrique, par exemple un onduleur.

### PRESENTATION DE L'INVENTION

Plus précisément, l'invention a pour objet un ensemble électrique comprenant :
- un support, comprenant un dispositif de refroidissement configuré pour dissiper de la chaleur émise par une capacité de liaison;
- un élément séparateur, disposé entre le dispositif de refroidissement et la capacité de liaison, configuré pour réaliser une isolation électrique entre la capacité de liaison et le dispositif de refroidissement ;
- ladite capacité de liaison, comprenant au moins une bobine capacitive et au moins une barre de connexion électrique fixée à ladite au moins une bobine capacitive, ladite au moins une barre de connexion électrique étant au moins en partie disposée du côté de l'élément séparateur ;

l'ensemble électrique comprenant des premiers organes de maintien de l'élément séparateur sur ledit support,
ledit élément séparateur intégrant par ailleurs des seconds organes de maintien adaptés pour assurer le maintien de la capacité de liaison sur l'élément séparateur et ledit élément séparateur étant en plastique et les seconds organes de maintien comprenant des bouterolles à rivet issues de matière de l'élément séparateur et s'étendant depuis l'élément séparateur vers la capacité de liaison, lesdites bouterolles étant configurées pour s'écraser sous la pression, lors de l'assemblage de l'ensemble électrique, de façon à former des zones de liaison entre l'élément séparateur et la capacité de liaison.

En particulier, l'invention permet, après retournement de l'ensemble électrique, la capacité étant au bas de l'ensemble électrique et le support étant en haut de l'ensemble électrique, l'insertion dans ce sens dudit ensemble électrique dans un châssis d'équipement électrique.

Selon un mode de réalisation, au moins une partie desdites bouterolles sont configurées pour réaliser des zones de liaison entre ledit élément séparateur et ladite au moins barre de connexion électrique.

Selon un mode de réalisation, les premiers organes de maintien comprennent des bouterolles supplémentaires issues de matière et s'étendant depuis l'élément séparateur vers le support, lesdites bouterolles supplémentaires étant configurées pour s'écraser sous la pression, lors du montage de l'ensemble électrique, de façon à former des zones de liaison entre le support et l'élément séparateur, pour que l'ensemble électrique forme un ensemble solidaire apte au retournement au terme duquel la capacité de liaison se trouve en bas de l'ensemble électrique en vue de l'insertion dudit ensemble électrique dans un châssis de l'équipement électrique.

Selon un mode de réalisation, les premiers organes de maintien comprennent des bouterolles complémentaires issues de matière du support, et s'étendant depuis le dispositif de refroidissement, vers l'élément séparateur, lesdites bouterolles complémentaires étant configurées pour s'écraser sous la pression, lors de l'assemblage de l'ensemble électrique, de façon à former des zones de liaison entre le support et l'élément séparateur, pour que l'ensemble électrique forme un ensemble solidaire apte au retournement au terme duquel la capacité de liaison se trouve en bas de l'ensemble électrique en vue de l'insertion dudit ensemble électrique dans un châssis de l'équipement électrique.

Avantageusement, l'ensemble électrique peut comprendre un élément d'isolation électrique, notamment une feuille d'isolation électrique, disposée entre la capacité de liaison et le support, pour isoler ladite au moins une barre de connexion électrique et augmenter la ligne de fuite pour des courants de fuite susceptible de se propager via des surfaces de l'élément séparateur et/ou du coussin de dissipation thermique.

Selon un mode de réalisation, ladite au moins une barre de connexion électrique comporte des bornes de connexion électrique, extrémales, s'étendant au moins d'un côté de ladite au moins une bobine et ledit élément d'isolation électrique comporte une extension configurée pour s'étendre au moins en vis-à-vis de l'ensemble desdites bornes de connexion électrique.

Selon un mode de réalisation, l'élément séparateur comprend une surface de base et au moins une paroi de guidage s'étendant orthogonalement à ladite surface de base, en direction de la capacité de liaison, et le support comprend au moins une embouchure tubulaire formant une entrée ou une sortie de fluide de refroidissement du dispositif de refroidissement, ladite embouchure tubulaire s'étendant orthogonalement audit support, en direction de la capacité de liaison, ladite au moins une paroi de guidage étant configurée pour coopérer avec ladite au moins une embouchure tubulaire de sorte à participer au positionnement de l'élément séparateur et donc de la capacité de liaison sur ledit support.

Selon un mode de réalisation, le dispositif de refroidissement fait partie intégrante du support.

Selon un mode de réalisation, l'élément séparateur est configuré pour recevoir un coussin de dissipation thermique, ledit élément séparateur et pour limiter le taux de compression du coussin de dissipation thermique de sorte à garantir une épaisseur minimale prédéfinie dudit coussin de dissipation thermique.

L'élément séparateur permet aussi de maintenir une constance de l'épaisseur du coussin de dissipation thermique et de ses propriétés thermiques dans le temps.

Selon un mode de réalisation, la capacité est une capacité de liaison configurée pour filtrer un signal électrique continu.

Avantageusement, le support, le dispositif de refroidissement, est er aluminium, et l'élément séparateur est en plastique, notamment en PBT GF30.

L'invention vise aussi un équipement électrique, un onduleur, comprenant ur châssis, formant un boîtier avec un fond et des parois latérales, et un ensemble électrique selon tel que brièvement décrit ci-dessus, ledit ensemble électrique étant inséré à l'intérieur dudit châssis.

Avantageusement, le support forme un couvercle dudit équipement électrique.

Avantageusement, ledit ensemble électrique est fixé à un élément solidaire dudit châssis.

Avantageusement, ledit élément solidaire du châssis est une portion du châssis lui-même ou une plaque support intermédiaire ou une portion d'un circuit de refroidissement appartenant audit équipement électrique et fixé audit châssis.

Avantageusement, ledit ensemble électrique est fixé à un élément solidaire dudit châssis, au moins en partie par l'intermédiaire de bouterolles en aluminium issues de matière de ladite portion de châssis ou de ladite plaque support intermédiaire ou de ladite portion d'un circuit de refroidissement.

Selon un mode de réalisation, l'équipement électrique est un onduleur électrique, notamment pour un véhicule automobile.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
[Fig. 1] : la figure 1 est une représentation schématique d'un exemple d'ensemble électrique selon l'invention, comprenant des composants additionnels ;
[Fig. 2] : la figure 2 est une représentation schématique d'un exemple d'ensemble électrique selon l'invention ;
[Fig. 3] : la figure 3 est une représentation schématique de la capacité de liaison prévue dans les exemples d'ensemble électrique selon l'invention représentés sur les figures 1 et 2 ;
[Fig. 4] : la figure 4 est une représentation schématique de l'élément séparateur logeant un coussin de dissipation thermique, tel que prévue dans les exemples d'ensemble électrique selon l'invention représentés sur les figures 1 et 2 ;
[Fig. 5] : la figure 5 est une représentation schématique du module de refroidissement prévue dans les exemples d'ensemble électrique selon l'invention représentés sur les figures 1 et 2.

Il faut noter que les figures exposent l'invention de manière détaillée pour permettre de mettre en oeuvre l'invention, lesdites figures pouvant bien entendu servir à mieux définir l'invention le cas échéant.

### DESCRIPTION DETAILLEE DE L'INVENTION

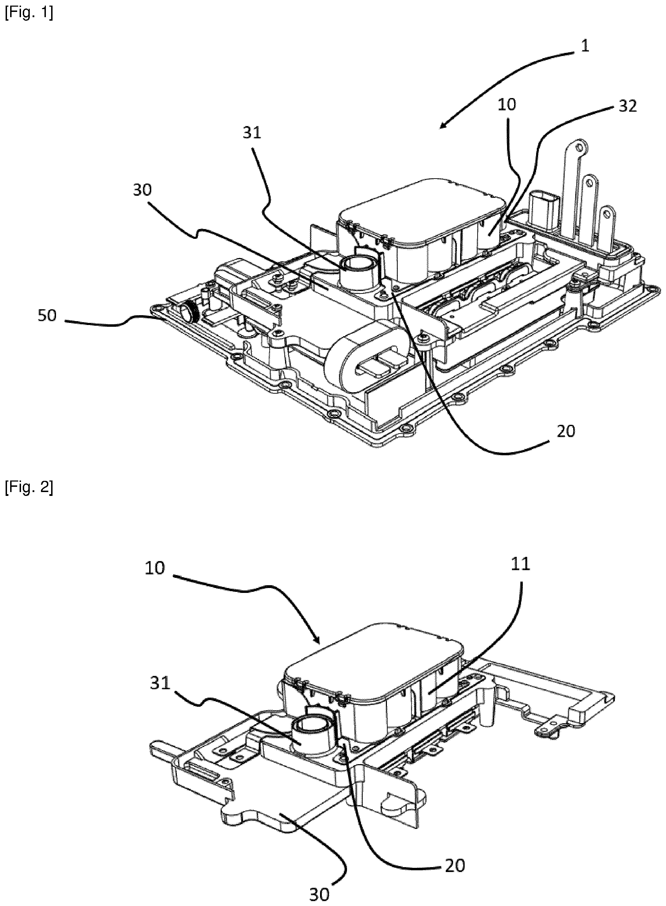

Comme représenté sur la figure 1, qui montre un exemple de réalisation, la présente invention concerne un ensemble électrique 1.Le mode de réalisation de la figure 1 représente un ensemble électrique 1 comprenant notamment une capacité de liaison 10 dotée d'une première barre de connexion électrique 12 correspondant à une borne de connexion électrique 120 de charge positive et d'une deuxième barre de connexion électrique 13 correspondant à une borne de connexion électrique 130 de charge négative. Comme cela est connu, la capacité de liaison 10 est un composant électrique de filtrage configuré d'une part pour atténuer des perturbations des signaux de courant transférés via l'équipement électrique considéré et d'autre part pour constituer une réserve de tension destinée à alimenter des composants dudit équipement électrique.

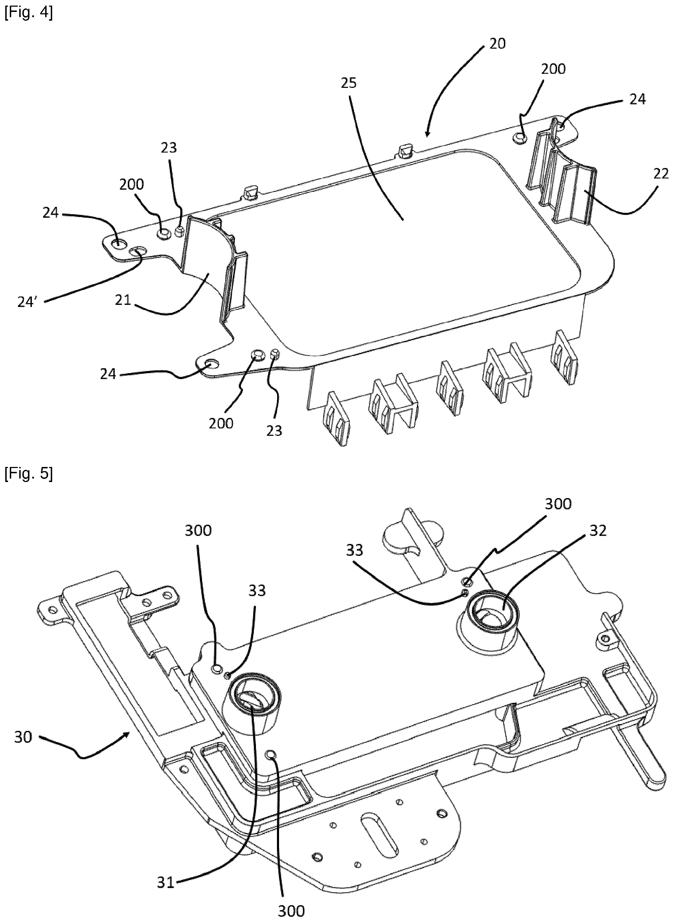

L'ensemble électrique 1 comprend en outre un élément séparateur 20 recevant un coussin de dissipation thermique 25 (visible sur la figure 4) disposé entre ladite capacité de liaison 10 et un dispositif de refroidissement 30.

Ce dispositif de refroidissement 30 est ici fixé, par l'intermédiaire de vis au support 50, mais il pourrait alternativement en faire partie intégrante. Le dispositif de refroidissement 30 est par exemple en aluminium.

Le dispositif de refroidissement 30, avec le support 50 auquel il est fixé ou intégré, forme une base sur laquelle sont assemblés l'élément séparateur 20 recevant le coussin de dissipation thermique 25 et la capacité de liaison 10.

Dans un processus d'assemblage d'un équipement électrique, on constitue par conséquent d'abord l'ensemble électrique 1, tel que celui représenté sur la figure 1. Sur un support, on assemble dans cet ordre l'élément séparateur 20 recevant le coussin de dissipation thermique 25 et la capacité de liaison 10. Bien entendu, d'autres composants électriques ou mécaniques et/ou une ou plusieurs cartes électroniques peuvent être fixés à un moment choisi sur l'un des éléments précités de l'ensemble électrique 1. Le support comprend de préférence un support 50 qui intègre le dispositif de refroidissement 30. Alternativement, ledit dispositif de refroidissement 30 est fixé audit support 50, par exemple par l'intermédiaire de vis ou de gougeons ou de tout autre moyen équivalent.

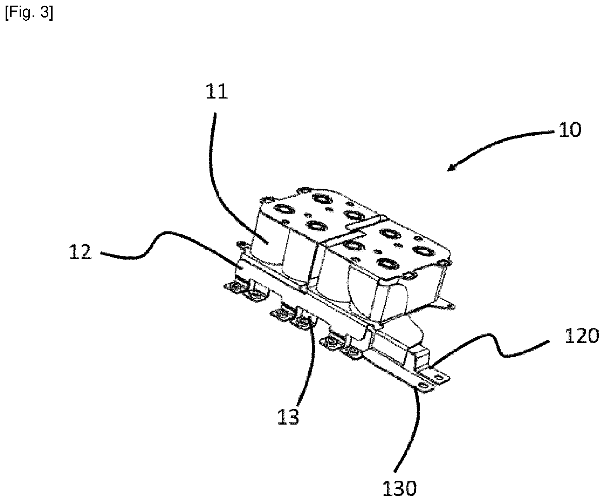

Comme cela est visible sur les figures 2 et 3, la capacité de liaison 10 comprend une pluralité de bobines 11 auxquelles sont soudées les premières et deuxième barre de connexion électriques 12, 13 aux extrémités desquelles se trouvent respectivement une borne de connexion électrique 120 positive et une borne de connexion électrique 130 négative.

Le dispositif de refroidissement 30 est représenté en figure 5 et est visible en figure 2. Ledit dispositif de refroidissement 30 est configuré pour dissiper la chaleur émise par la capacité de liaison 10. Le dispositif de refroidissement 30 comprend une entrée 31 et une sortie 32 de fluide de refroidissement pour permettre l'entrée et la sortie d'un fluide caloporteur chargé de dissiper la chaleur émise par la capacité de liaison 10. Cette entrée 31 et cette sortie 32 de fluide de refroidissement forment des portions tubulaires s'étendant orthogonalement à la surface de base du dispositif de refroidissement 30, en direction de la capacité de liaison 10, notamment de part et d'autre de cette dernière.

En référence à la figure 4, l'élément séparateur 20 disposé entre la capacité de liaison 10 et le dispositif de refroidissement 30 assure un rôle essentiel. Ledit élément séparateur 20 forme un cadre principalement plan, avec une surface de base en forme de cadre rectangulaire, en particulier en plastique. Au centre de ce cadre est reçu un coussin de dissipation thermique 25 (« gap pad » en anglais) destiné à être comprimé au contact de la capacité de liaison 10 pour dissiper de la chaleur émise par cette dernière.

L'élément séparateur 20 est notamment en plastique rigide, par exemple en PBT GF30. Une fonction de cet élément séparateur 20 est de limiter la compression du coussin de dissipation thermique 25 de sorte à garantir que ladite compression reste inférieure à un seuil prédéfini, notamment de l'ordre de 30% pour un coussin de dissipation thermique 25. Ainsi, le coussin de dissipation thermique 25 conserve une épaisseur minimale souhaitée, lui permettant d'assurer efficacement une fonction de dissipation thermique, ladite épaisseur minimale du coussin de dissipation thermique 25 étant environ égale à l'épaisseur de l'élément séparateur 20.

Selon le mode de réalisation représenté, l'élément séparateur 20 comporte en outre des parois de guidage 21, 22 correspondant à des parois s'étendant orthogonalement à une surface de base de l'élément séparateur 20, en direction de la capacité de liaison 10, notamment de part et d'autre de ladite capacité de liaison 10, de façon à épouser sensiblement, à des fins de guidage, une partie de l'entrée 31 et de la sortie 32 de fluide de refroidissement, de forme tubulaire, appartenant au dispositif de refroidissement 30.

Durant le montage de l'ensemble électrique 1, il est ainsi prévu que l'on empile, de bas en haut et dans cet ordre, l'élément séparateur 20, le coussin de dissipation thermique 25 qui se loge dans le cadre formé par ledit élément séparateur 20, puis la capacité de liaison 10. De préférence, l'élément séparateur 20 comprend des plots de centrage 23 issus de matière dudit élément séparateur 20 et permettant l'indexation, autrement dit le positionnement ou le centrage, de la capacité de liaison 10 sur ledit élément séparateur 20. En outre, l'élément séparateur 20 comprend des bouterolles 200 (décrites dans le détail ci-après) formant des protubérances issues de sa masse et permettant de réaliser un rivetage ou bouterollage pour assurer le maintien de la capacité de liaison 10 sur l'élément séparateur 20. Après avoir empilé les différents éléments, on amène ainsi un outil dédié pour déformer les bouterolles. Le bon positionnement de la capacité de liaison 10 facilite le vissage de l'ensemble électrique 1 dans le châssis pour former l'équipement électrique.

Ainsi, les bouterolles, comme cela est connu, sont des protubérances, par exemple en forme de champignons, issues de matière d'un élément à fixer à un autre élément. Notamment, des bouterolles 200 en plastique, issues de matière de l'élément séparateur 20 sont prévues, selon un mode de réalisation, pour fixer la capacité de liaison 10 audit élément séparateur 20.

Le sous-ensemble constitué de l'élément séparateur 20, du coussin de dissipation thermique 25 et de la capacité de liaison 10 est disposé sur le dispositif de refroidissement 30 fixé au support 50 ou intégré à ce dernier. Comme expliqué ci-dessus, les parois de guidage 21, 22 coopèrent avec l'entrée 31 et la sortie 32 de fluide de refroidissement du dispositif de refroidissement 30 pour permettre le guidage, autrement dit le centrage, dudit sous-ensemble sur le dispositif de refroidissement 30, fixé au support 50 ou intégré à ce dernier, formant le support de l'ensemble électrique 1. Des seconds plots de centrage 33 sont de préférence prévus sur le dispositif de refroidissement, comme cela est visible sur la figure 5, formant des plots issus de matière du dispositif de refroidissement 30, pour assurer le positionnement de l'élément séparateur 20 sur ledit dispositif de refroidissement 30. Les seconds plots de centrage 33 passent par les ouvertures 24' de l'élément séparateur 20.

Toujours en référence à la figure 5, des bouterolles 300 peuvent être prévues sur le dispositif de refroidissement 30 qui est par exemple constitué d'aluminium. Les bouterolles 300 correspondantes sont alors en aluminium et permettent la fixation de l'élément séparateur 20 sur le dispositif de refroidissement 30. Notamment, les bouterolles 300 en aluminium passent par les ouvertures 24 de l'élément séparateur 20 avant d'être bouterollées et ainsi de fixer l'élément séparateur 20 sur le dispositif de refroidissement 30.

Selon un mode de réalisation, on prévoit donc des bouterolles 200 en plastique issues de matière de l'élément séparateur 20 pour assurer le maintien de la capacité de liaison 10 sur l'élément séparateur 20. Par ailleurs, d'autres bouterolles en plastique issues de matière de l'élément séparateur 20 et/ou des bouterolles 300 en aluminium issues de matière du dispositif de refroidissement 30 peuvent être prévues pour assurer le maintien de l'élément séparateur 20 sur ledit dispositif de refroidissement 30.

Les bouterolles sont également communément désignées des gaudrons déformables.

Une feuille d'isolation électrique est de préférence disposée entre l'élément séparateur 20 et le dispositif de refroidissement 30. Ladite feuille d'isolation électrique permet d'augmenter le chemin de fuite pour d'éventuels courants de fuite se propageant via le coussin de dissipation thermique 25 ou l'élément séparateur 20. La feuille d'isolation électrique peut aussi être intégrée dans le coussin de dissipation thermique 25. La longueur des chemins de fuite est en général définie par des normes et standards connus de l'homme du métier, en fonction du domaine d'utilisation et des puissances mises en oeuvre notamment. En outre, une extension de ladite feuille d'isolation électrique peut être prévue pour venir en vis-à-vis des bornes de connexion électrique positive 120 et négative 130 et ainsi isoler lesdites bornes de connexion électrique 120, 130 de la capacité de liaison 10 par rapport au dispositif de refroidissement 30 et au support 50 et, plus généralement, par rapport au châssis de l'équipement électrique considéré.

Les bouterolles 200, 300 forment donc des champignons de matière qui sont écrasés, par compression, et/ou sous chaleur, pour réaliser des zones de liaison entre les éléments pressés l'un contre l'autre. Notamment, les bouterolles 200 en plastique prévues pour maintenir la capacité de liaison 10 sur l'élément séparateur 20 peuvent être disposées pour réaliser des zones de liaison entre l'élément séparateur 20 dont elles sont issues et les barres de connexion électrique de la capacité de liaison 10.

Il faut noter que les bouterolles 200 en plastique sont réalisées par déformation, par application d'une pression adaptée, avec apport de chaleur. Les bouterolles 300 en aluminium sont réalisées par déformation, par application d'une pression adaptée, sans apport de chaleur.

Les bouterolles 200 en plastiques prévues sur l'élément séparateur 20 sont obtenues notamment par moulage. Les bouterolles 300 en aluminium prévues sur le dispositif de refroidissement 30 sont obtenues par moulage aluminium avec éventuellement un usinage complémentaire en fonction du besoin.

Il est noté que les bouterolles 200, 300 constituent un moyen préféré de réalisation pour assurer le maintien de la capacité de liaison 10 sur l'élément séparateur 20 et de l'élément séparateur 20 sur le dispositif de refroidissement 30 (fixé ou intégré au support 50). Toutefois, d'autres moyens de maintien alternatifs sont possibles, notamment des vis ou des clips de maintien.

Ainsi maintenu de façon à former un ensemble solidaire, autrement dit d'un seul tenant, en particulier à des bouterolles en plastique 200 et/ou en aluminium 300, permettant le maintien de la capacité de liaison 10 sur l'élément séparateur 20 et le maintien de l'élément séparateur 20 sur le dispositif de refroidissement 30 et le support 50, ledit ensemble électrique 1 peut être retourné, la capacité de liaison 10 se retrouvant au bas de l'ensemble électrique 1, et le support 50 en haut, sans que la capacité de liaison 10 ne tombe, afin d'être inséré dans un châssis en vue de l'assemblage de l'équipement électrique.

L'ensemble électrique 1 est en particulier fixé à un élément solidaire dudit châssis, tel qu'une portion du châssis lui-même, une plaque support intermédiaire fixée audit châssis (« bracket » en anglais) ou une portion d'un circuit de refroidissement appartenant audit équipement électrique et logé ou intégré dans ledit châssis.

Notamment, ledit ensemble électrique 1 est par exemple fixé à un élément solidaire du châssis par l'intermédiaire de bouterolles en aluminium issues de matière de ladite portion de châssis ou de ladite plaque support intermédiaire ou de ladite portion d'un circuit de refroidissement

L'équipement électrique est par exemple un onduleur pour un véhicule automobile électrique ou hybride.

Il est noté que ce maintien de l'ensemble électrique 1 en un ensemble solidaire, en particulier grâce à des bouterolles 200, 300, n'a pas nécessairement vocation à être pérenne. En effet, il peut ne pas y avoir d'autre fonction que ce maintien de l'ensemble électrique 1 en un ensemble solidaire de façon provisoire, en raison du transport ou de l'étape nécessaire de retournement dudit ensemble électrique 1 pour permettre son insertion dans le châssis pour former l'équipement électrique considéré. Une fois cette insertion réalisée, des moyens de fixation définitives sont normalement prévues pour fixer de façon pérenne ledit ensemble électrique 1 audit châssis, notamment par des vis par exemple ou encore par des éléments internes de maintien sous pression, tels que des ressorts.

## Revendications

1. Ensemble électrique (1) comprenant :
- un support (50), comprenant un dispositif de refroidissement (30) configuré pour dissiper de la chaleur émise par une capacité de liaison (10) ;
- un élément séparateur (20) disposé entre le dispositif de refroidissement (30) et la capacité de liaison (10) configuré pour réaliser une isolation électrique entre la capacité de liaison (10) et le dispositif de refroidissement (30) ;
- ladite capacité de liaison (10), comprenant au moins une bobine capacitive (11) et au moins une barre de connexion électrique (12, 13) fixée à ladite au moins une bobine capacitive (11), ladite au moins une barre de connexion électrique (12, 13) étant au moins en partie disposée du côté de l'élément séparateur (20) ;
l'ensemble électrique (1) comprenant des premiers organes de maintien de l'élément séparateur (20) sur ledit support,
ledit élément séparateur (20) intégrant par ailleurs des seconds organes de maintien adaptés pour assurer le maintien de la capacité de liaison (10) sur l'élément séparateur (20) et ledit élément séparateur (20) étant en plastique et les seconds organes de maintien comprenant des bouterolles (200) à rivet issues de matière de l'élément séparateur (20) et s'étendant depuis l'élément séparateur (20) vers la capacité de liaison (10), lesdites bouterolles (200) étant configurées pour s'écraser sous la pression, lors de l'assemblage de l'ensemble électrique (1), de façon à former des zones de liaison entre l'élément séparateur (20) et la capacité de liaison (10).

2. Ensemble électrique (1) selon la revendication 1, dans lequel au moins une partie desdites bouterolles (200) sont configurées pour réaliser des zones de liaison entre ledit élément séparateur (20) et ladite au moins barre de connexion électrique (12, 13).

3. Ensemble électrique (1) selon l'une quelconque des revendications précédentes, dans lequel les premiers organes de maintien comprennent des bouterolles supplémentaires issues de matière et s'étendant depuis l'élément séparateur (20) vers le support (50), lesdites bouterolles supplémentaires étant configurées pour s'écraser sous la pression, lors du montage de l'ensemble électrique (1), de façon à former des zones de liaison entre le support (50) et l'élément séparateur (20), pour que l'ensemble électrique (1) forme un ensemble solidaire apte au retournement au terme duquel la capacité de liaison (10) se trouve en bas de l'ensemble électrique (1) en vue de l'insertion dudit ensemble électrique (1) dans un châssis de l'équipement électrique.

4. Ensemble électrique (1) selon l'une quelconque des revendications précédentes, dans lequel les premiers organes de maintien comprennent des bouterolles complémentaires (300) issues de matière du support, et s'étendant depuis le dispositif de refroidissement (30), vers l'élément séparateur (20), lesdites bouterolles complémentaires (300) étant configurées pour s'écraser sous la pression, lors de l'assemblage de l'ensemble électrique (1), de façon à former des zones de liaison entre le support et l'élément séparateur (20), pour que l'ensemble électrique (1) forme un ensemble solidaire apte au retournement au terme duquel la capacité de liaison (10) se trouve en bas de l'ensemble électrique (1) en vue de l'insertion dudit ensemble électrique (1) dans un châssis de l'équipement électrique.

5. Ensemble électrique (1) selon l'une des revendications précédentes, dans lequel l'élément séparateur (20) comprend une surface de base et au moins une paroi de guidage (21, 22) s'étendant orthogonalement à ladite surface de base, en direction de la capacité de liaison (10), et le support comprend au moins une embouchure tubulaire (31, 32) formant une entrée (31) ou une sortie (32) de fluide de refroidissement du dispositif de refroidissement (30), ladite embouchure tubulaire (31, 32) s'étendant orthogonalement audit support, en direction de la capacité de liaison (10), ladite au moins une paroi de guidage (21, 22) étant configurée pour coopérer avec ladite au moins une embouchure tubulaire (31, 32) de sorte à participer au positionnement de l'élément séparateur (20) et donc de la capacité de liaison (10) sur ledit support.

6. Ensemble électrique (1) selon l'une des revendications précédentes, dans lequel le dispositif de refroidissement (30) fait partie intégrante du support (50).

7. Ensemble électrique (1) selon l'une des revendications précédentes, dans lequel l'élément séparateur (20) est configuré pour recevoir un coussin de dissipation thermique (25), ledit élément séparateur (20) étant configuré pour limiter le taux de compression du coussin de dissipation thermique (25) de sorte à garantir une épaisseur minimale prédéfinie dudit coussin de dissipation thermique (25).

8. Ensemble électrique (1) selon l'une des revendications précédentes, dans lequel le support, le dispositif de refroidissement (30), est en aluminium, et l'élément séparateur (20) est en plastique, notamment en PBT GF30.

9. Equipement électrique, un onduleur, comprenant un châssis, formant un boîtier avec un fond et des parois latérales, et un ensemble électrique (1) selon l'une des revendications précédentes, ledit ensemble électrique (1) étant inséré à l'intérieur dudit châssis.

10. Equipement électrique selon la revendication 9, dans lequel le support (50) forme un couvercle dudit équipement électrique.

11. Equipement électrique selon la revendication 9 ou 10, dans lequel ledit ensemble électrique (1) est fixé à un élément solidaire dudit châssis.

12. Equipement électrique selon la revendication précédente, dans lequel ledit élément solidaire du châssis est une portion du châssis lui-même ou une plaque support intermédiaire ou une portion d'un circuit de refroidissement appartenant audit équipement électrique et fixé audit châssis.

13. Equipement électrique selon la revendication précédente, dans lequel ledit ensemble électrique (1) est fixé à un élément solidaire dudit châssis, au moins en partie par l'intermédiaire de bouterolles en aluminium issues de matière de ladite portion de châssis ou de ladite plaque support intermédiaire ou de ladite portion d'un circuit de refroidissement.

14. Equipement électrique selon l'une des revendications 9 à 13, est un onduleur électrique, notamment pour un véhicule automobile.

## Patentansprüche

1. Elektrische Anordnung (1), umfassend:
- einen Träger (50), der eine Kühlvorrichtung (30) umfasst, die dazu eingerichtet ist, Wärme abzuleiten, die von einer Verbindungskapazität (10) abgegeben wird;
- ein Trennelement (20), das zwischen der Kühlvorrichtung (30) und der Verbindungskapazität (10) angeordnet ist, das dazu eingerichtet ist, eine elektrische Isolierung zwischen der Verbindungskapazität (10) und der Kühlvorrichtung (30) herzustellen;
- wobei die Verbindungskapazität (10) wenigstens eine kapazitive Spule (11) und wenigstens eine elektrische Verbindungsschiene (12, 13) umfasst, die an der wenigstens einen kapazitiven Spule (11) befestigt ist, wobei die wenigstens eine elektrische Verbindungsschiene (12, 13) wenigstens teilweise auf der Seite des Trennelements (20) angeordnet ist;
wobei die elektrische Anordnung (1) erste Organe zum Halten des Trennelements (20) auf dem Träger umfasst, wobei das Trennelement (20) ferner zweite Halteorgane aufweist, die geeignet sind, den Halt der Verbindungskapazität (10) auf dem Trennelement (20) zu gewährleisten, und das Trennelement (20) aus Kunststoff ist und die zweiten Halteorgane Nietstempel (200) umfassen, die mit dem Trennelement (20) einstückig sind und sich vom Trennelement (20) zur Verbindungskapazität (10) erstrecken, wobei die Nietstempel (200) dazu eingerichtet sind, unter dem Druck bei der Montage der elektrischen Anordnung (1) zusammengedrückt zu werden, um Verbindungsbereiche zwischen dem Trennelement (20) und der Verbindungskapazität (10) zu bilden.

2. Elektrische Anordnung (1) nach Anspruch 1, wobei wenigstens einige der Nietstempel (200) dazu eingerichtet sind, Verbindungsbereiche zwischen dem Trennelement (20) und der wenigstens einen elektrischen Verbindungsschiene (12, 13) herzustellen.

3. Elektrische Anordnung (1) nach einem der vorhergehenden Ansprüche, wobei die ersten Halteorgane zusätzliche einstückig geformte Nietstempel umfassen, und sich vom Trennelement (20) zum Träger (50) erstrecken, wobei die zusätzlichen Nietstempel dazu eingerichtet sind, unter dem Druck bei der Montage der elektrischen Anordnung (1) zusammengedrückt zu werden, um Verbindungsbereiche zwischen dem Träger (50) und dem Trennelement (20) zu bilden, damit die elektrische Anordnung (1) eine fest verbundene Anordnung bildet, die zum Umdrehen geeignet ist, wonach sich die Verbindungskapazität (10) im Hinblick auf das Einsetzen der elektrischen Anordnung (1) in einen Rahmen der elektrischen Ausrüstung unten an der elektrischen Anordnung (1) befindet.

4. Elektrische Anordnung (1) nach einem der vorhergehenden Ansprüche, wobei die ersten Halteorgane ergänzende Nietstempel (300) umfassen, die mit dem Träger einstückig geformt sind und sich von der Kühlvorrichtung (30) zum Trennelement (20) erstrecken, wobei die ergänzenden Nietstempel (300) dazu eingerichtet sind, unter dem Druck bei der Montage der elektrischen Anordnung (1) zusammengedrückt zu werden, um Verbindungsbereiche zwischen dem Träger (1) und dem Trennelement (20) zu bilden, damit die elektrische Anordnung (1) eine fest verbundene Anordnung bildet, die zum Umdrehen geeignet ist, wonach sich die Verbindungskapazität (10) im Hinblick auf das Einsetzen der elektrischen Anordnung (1) in einen Rahmen der elektrischen Ausrüstung unten an der elektrischen Anordnung (1) befindet.

5. Elektrische Anordnung (1) nach einem der vorhergehenden Ansprüche, wobei das Trennelement (20) eine Grundfläche und wenigstens eine Führungswand (21, 22), die sich orthogonal zur Grundfläche in Richtung der Verbindungskapazität (10) erstreckt, umfasst, und der Träger wenigstens eine röhrenförmige Mündung (31, 32) umfasst, die einen Einlass (31) oder einen Auslass (32) für Kühlfluid der Kühlvorrichtung (30) bildet, wobei sich die röhrenförmige Mündung (31, 32) orthogonal zum Träger in Richtung der Verbindungskapazität (10) erstreckt, wobei die wenigstens eine Führungswand (21, 22) dazu eingerichtet ist, mit der wenigstens einen röhrenförmigen Mündung (31, 32) so zusammenzuwirken, dass sie an der Positionierung des Trennelements (20) und somit der Verbindungskapazität (10) auf dem Träger beteiligt ist.

6. Elektrische Anordnung (1) nach einem der vorhergehenden Ansprüche, wobei die Kühlvorrichtung (30) fester Bestandteil des Trägers (50) ist.

7. Elektrische Anordnung (1) nach einem der vorhergehenden Ansprüche, wobei das Trennelement (20) dazu eingerichtet ist, ein Wärmeableitungspad (25) aufzunehmen, wobei das Trennelement (20) dazu eingerichtet ist, den Kompressionsgrad des Wärmeableitungspads (25) zu begrenzen, um eine vorgegebene Mindestdicke des Wärmeableitungspads (25) zu garantieren.

8. Elektrische Anordnung (1) nach einem der vorhergehenden Ansprüche, wobei der Träger, die Kühlvorrichtung (30) aus Aluminium ist und das Trennelement (20) aus Kunststoff ist, insbesondere aus PBT GF30.

9. Elektrische Anordnung, Wechselrichter, umfassend einen Rahmen, der ein Gehäuse mit einem Boden und Seitenwänden bildet, und eine elektrische Anordnung (1) nach einem der vorhergehenden Ansprüche, wobei die elektrische Anordnung (1) ins Innere des Rahmens eingesetzt ist.

10. Elektrische Ausrüstung nach Anspruch 9, wobei der Träger (50) einen Deckel der elektrischen Ausrüstung bildet.

11. Elektrische Ausrüstung nach Anspruch 9 oder 10, wobei die elektrische Anordnung (1) an einem Element befestigt ist, das mit dem Rahmen fest verbunden ist.

12. Elektrische Ausrüstung nach dem vorhergehenden Anspruch, wobei das Element, das mit dem Rahmen fest verbunden ist, ein Abschnitt des Rahmens selbst oder eine dazwischenliegende Trägerplatte oder ein Abschnitt eines Kühlkreislaufs ist, der zu der elektrischen Ausrüstung gehört und am Rahmen befestigt ist.

13. Elektrische Ausrüstung nach dem vorhergehenden Anspruch, wobei die elektrische Anordnung (1) an einem Element, das mit dem Rahmen fest verbunden ist, wenigstens teilweise durch Nietstempel aus Aluminium befestigt ist, die einstückig mit dem Rahmenabschnitt oder der dazwischenliegenden Trägerplatte oder dem Abschnitt eines Kühlkreislaufs geformt sind.

14. Elektrische Ausrüstung nach einem der Ansprüche 9 bis 13, ein elektrischer Wechselrichter ist, insbesondere für ein Kraftfahrzeug.

## Claims

1. Electrical assembly (1) comprising:
- a support (50), comprising a cooling device (30) configured to dissipate heat emitted by a link capacitor (10) ;
- a separating element (20) disposed between the cooling device (30) and the link capacitor (10) configured to produce an electrical insulation between the link capacitor (10) and the cooling device (30);
- said link capacitor (10) comprising at least one capacitive coil (11) and at least one electrical connection bar (12, 13) fixed to said at least one capacitive coil (11), said at least one electrical connection bar (12, 13) being at least partly disposed on the side of the separating element (20);
the electrical assembly (1) comprising first securing members for securing the separating element (20) on said support,
said separating element (20) also incorporating second securing members designed to ensure the securing of the link capacitor (10) on the separating element (20) and said separating element (20) being made of plastic and the second securing members comprising riveting heads (200) made in one piece with the separating element (20) and extending from the separating element (20) to the link capacitor (10), said heads (200) being configured to be crushed under the pressure, when the electrical assembly (1) is assembled, so as to form link zones between the separating element (20) and the link capacitor (10).

2. Electrical assembly (1) according to Claim 1, in which at least some of said heads (200) are configured to produce link zones between said separating element (20) and said at least one electrical connection bar (12, 13).

3. Electrical assembly (1) according to either one of the preceding claims, wherein the first securing members comprise additional heads made in one piece and extending from the separating element (20) towards the support (50), said additional heads being configured to be crushed under the pressure, when the electrical assembly (1) is mounted, so as to form link zones between the support (50) and the separating element (20), so that the electrical assembly (1) forms a solid assembly that can be turned over, after which the link capacitor (10) is located at the bottom of the electrical assembly (1) in order for said electrical assembly (1) to be inserted into a frame of the electrical equipment.

4. Electrical assembly (1) according to any one of the preceding claims, wherein the first securing members comprise complementary heads (300) made in a piece with the support, and extending from the cooling device (30), towards the separating element (20), said complementary heads (300) being configured to be crushed under the pressure, when the electrical assembly (1) is assembled, so as to form link zones between the support and the separating element (20), so that the electrical assembly (1) forms a solid assembly that can be turned over, after which the link capacitor (10) is located at the bottom of the electrical assembly (1) in order for said electrical assembly (1) to be inserted into a frame of the electrical equipment.

5. Electrical assembly (1) according to one of the preceding claims, wherein the separating element (20) comprises a base surface and at least one guiding wall (21, 22) extending orthogonally to said base surface, towards the link capacitor (10), and the support comprises at least one tubular opening (31, 32) forming an inlet (31) or an outlet (32) for cooling fluid of the cooling device (30), said tubular opening (31, 32) extending orthogonally to said support, towards the link capacitor (10), said at least one guiding wall (21, 22) being configured to cooperate with said at least one tubular opening (31, 32) so as to contribute to the positioning of the separating element (20) and therefore of the link capacitor (10) on said support.

6. Electrical assembly (1) according to one of the preceding claims, wherein the cooling device (30) forms an integral part of the support (50).

7. Electrical assembly (1) according to one of the preceding claims, wherein the separating element (20) is configured to receive a heat-dissipating cushion (25), said separating element (20) being configured to limit the rate of compression of the heat-dissipating cushion (25) so as to guarantee a predefined minimum thickness of said heat-dissipating cushion (25).

8. Electrical assembly (1) according to one of the preceding claims, wherein the support, the cooling device (30), is made of aluminium, and the separating element (20) is made of plastic, notably of PBT GF30.

9. Electrical equipment, or inverter, comprising a frame, forming a housing with a bottom and side walls, and an electrical assembly (1) according to one of the preceding claims, said electrical assembly (1) being inserted inside said frame.

10. Electrical equipment according to Claim 9, wherein the support (50) forms a cover of said electrical equipment.

11. Electrical equipment according to Claim 9 or 10, wherein said electrical assembly (1) is fixed to an element secured to said frame.

12. Electrical equipment according to the preceding claim, wherein said element secured to the frame is a portion of the frame itself or an intermediate support plate or a portion of a cooling circuit belonging to said electrical equipment and fixed to said frame.

13. Electrical equipment according to the preceding claim, wherein said electrical assembly (1) is fixed to an element secured to said frame, at least partly via heads made of aluminium made in one piece with said portion of frame or said intermediate support plate or said portion of a cooling circuit.

14. Electrical equipment according to one of Claims 9 to 13, is an electrical inverter, notably for a motor vehicle.
